# EUROPÄISCHE PATENTANMELDUNG

(11) **EP 3 261 253 A1**
(43) Veröffentlichungstag der Anmeldung: **27.12.2017**
(21) Anmeldenummer: 16176211.7
(22) Anmeldetag: 24.06.2016
(51) Int. Cl.: H03K 17/04, H03K 17/042, H03K 17/74, H03K 17/567, H02M 1/08

(54) **ANSTEUERVERFAHREN UND VORRICHTUNG ZUR KOMMUTIERUNG EINES PHASENSTROMS IM BRÜCKENZWEIG EINER BRÜCKENSCHALTUNG**

(71) Anmelder: Siemens Aktiengesellschaft, 80333 München (DE)
(72) Erfinder: Weis, Benno, 91334 Hemhofen (DE)

(57) **Zusammenfassung**

Die Erfindung betrifft ein Ansteuerverfahren für einen ersten Leistungshalbleiterchip (1, 12) mit einem ersten schaltbaren Leistungshalbleiter (T1, T) und einer ersten Freilaufdiode (D1, D) und für einen zweiten Leistungshalbleiterchip (1, 13) mit einem zweiten schaltbaren Leistungshalbleiter (T2, T) und einer zweiten Freilaufdiode (D2, D) in einem Brückenzweig (2) einer Brückenschaltung (3) zur Kommutierung eines Phasenstroms (IAC), wobei bis zu einem ersten Zeitpunkt (t1) an einem ersten Gate (G1, G) des ersten schaltbaren Leistungshalbleiters (T1, T) ein erstes negatives Ansteuerpotential (AP1-) anliegt und die erste Freilaufdiode (D1, D) einen ersten Diodenstrom (ID1) als Phasenstroms (IAC) führt, wobei ab dem ersten Zeitpunkt (t1) der erste schaltbare Leistungshalbleiter (T1, T) mittels eines ersten positiven Ansteuerpotentials (AP1+) eingeschaltet wird, wobei zu einem zweiten Zeitpunkt (t2) der zweite schaltbare Leistungshalbleiter (T2, T), mittels eines an seinem zweiten Gate (G2, G) durchgeführten Potentialwechsels von einem dritten negativen Ansteuerpotential (AP3-) auf ein zweites positives Ansteuerpotential (AP2+), eingeschaltet wird, wobei daraufhin eine Auswertung des ersten Diodenstroms (ID1) erfolgt, und wobei bei Vorliegen einer Stromreduzierung (RE) zu einem dritten Zeitpunkt (t3) der erste schaltbare Leistungshalbleiter (T1, T) mittels eines zweiten negativen Ansteuerpotentials (AP2-) abgeschaltet wird. Weiterhin betrifft die Erfindung eine Vorrichtung (24) zur Durchführung des Ansteuerverfahrens sowie einen Umrichter (15) mit der Vorrichtung.

## Beschreibung

Die Erfindung betrifft ein Ansteuerverfahren für Leistungshalbleiterchips mit jeweils schaltbarem Leistungshalbleiter und Freilaufdiode im Brückenzweig einer Brückenschaltung zur Kommutierung eines Phasenstroms, eine Vorrichtung zur Durchführung des Ansteuerverfahrens sowie einen Umrichter mit der Vorrichtung.

Aus dem Stand der Technik sind schaltbare Leistungshalbleiter bekannt, insbesondere IGBTs (Insulated-Gate Bipolar Transistor), welche gemeinsam mit einer Freilaufdiode in einem Leistungshalbleiterchip implementiert sind. Diese Leistungshalbleiterchips, auch bekannt als Reverse Conducting IGBTs with Diode Control (RCDC-IGBTs), wurden beispielsweise von der Firma Infineon Technologies AG unter dem Titel "6,5kV RCDC for Increased Power Density in IGBT-Modules" auf dem "26. International Symposium on Power Semiconductor Devices & IC's" vorgestellt (Dorothea Werber et al., Konferenzband der ISPSD 2014, Seiten 35-38, Waikoloa, HI, USA, ISBN 978-1-4799-2917-7).

Derartige Leistungshalbleiterchips werden immer öfter in Umrichtern der Antriebstechnik zur geregelten bzw. gesteuerten Energiebereitstellung elektrischer Antriebe eingesetzt. Oftmals aggregieren sich diese Leistungshalbleiterchips wiederum zu leistungselektronischen Halbleitermodulen, welche in Form von Brückenschaltungen, z.B. als Sechspuls-Brückenschaltung (B6-Brücke) für Drehstromanwendungen von elektrischen Antriebsumrichtern, ausgeführt sind, wobei jeder einzelne Leistungshalbleiterchip einer dezidierten Ansteuerung für dessen Schaltvorgänge bedarf.

Für den Einsatz von Leistungshalbleiterchips, welche als RCDC-IGBTs ausgebildet sind, besteht oft ebenfalls die Notwendigkeit im Betriebsfall Schaltverluste soweit wie möglich zu reduzieren. Dazu ist es notwendig, sich auch das Verhalten der integrierten Freilaufdiode während der Schaltvorgänge näher zu betrachten.

So führt der im oberen Teil eines Brückenzweigs einer Brückenschaltung angeordnete derartige Leistungshalbleiterchip, welcher den antiparallel mit der oberen Freilaufdiode verbundenen oberen schaltbaren Leistungshalbleiter aufweist, zu einem speziellen Zeitpunkt bzw. Betriebszustand aufgrund einer in der entsprechenden Wechselstromphase vorhandenen Induktivität den Strom aus dieser Wechselstromphase über seine obere Freilaufdiode, wobei sich zu diesem Zeitpunkt sowohl der obere wie auch der untere schaltbare Leistungshalbleiter des Brückenzweigs im gesperrten Zustand befinden.

Mit Einschalten des unteren schaltbaren Leistungshalbleiters des unteren Leistungshalbleiterchips wird der Strom von der oberen Freilaufdiode des oberen Leistungshalbleiterchips an den unteren schaltbaren Leistungshalbleiters übergeben, welcher ebenfalls eine antiparallel mit ihm verbundene untere Freilaufdiode aufweist. Es findet somit eine Kommutierung des Stroms im Brückenzweig der Brückenschaltung statt, wobei die obere Freilaufdiode des oberen Leistungshalbleiterchips während dieses Kommutierungsvorgang Schaltverluste beim Übergang von einem leitenden Zustand in einen sperrenden Zustand erzeugt. Dieser Kommutierungsvorgang bzw. die Kommutierung des Stroms ist der technische Hintergrund der vorliegenden Patentschrift.

Die gemeinsam mit dem schaltbaren Leistungshalbleiter auf dem Leistungshalbleiterchip implementierte Freilaufdiode eröffnet Möglichkeiten, die Leitfähigkeit der Freilaufdiode mittels eines am Gate des schaltbaren Leistungshalbleiters anliegenden Ansteuerpotentials (Gate-Emitter-Spannung) zu beeinflussen. Leitet die Freilaufdiode den Strom, sinkt deren Vorwärtsspannung, also die Spannung der Freilaufdiode in Flussrichtung, zunehmend mit dem am Gate des schaltbaren Leistungshalbleiters (bzw. am Gate des leistungselektronischen Chips) anliegenden negativerem Ansteuerpotentials. Dadurch werden verstärkt Ladungsträger (Minoritätsladungsträger) in die Freilaufdiode injiziert, welche die Leitfähigkeit der Freilaufdiode verbessern.

Es besteht nunmehr die Motivation, während der beschriebenen Stromführung der Freilaufdiode das Gate-Ansteuerpotential auf einen deutlich negativen Wert, z.B. -15V, zu legen. Dieser Wert kann einem Gate-Sperrpotential entsprechen, welches an das Gate von schaltbaren Leistungshalbleitern üblicherweise dann angelegt wird, wenn sich diese in einem sicheren gesperrten Zustand befinden oder befinden sollen. Als sicherer gesperrter Zustand wird im Allgemeinen ein Zustand angenommen, bei dem kein Stromfluss zwischen Collector und Emitter im schaltbaren Leistungshalbleiter zustande kommt oder kommen soll, also die Collector-Emitter-Strecke sehr hochohmig wird oder ist.

Kommutiert der Strom, welcher durch die obere Freilaufdiode des Leistungshalbleiterchips fließt, ohne Vorhaltung weiterer Maßnahmen an den unteren schaltbaren Leistungshalbleiter des unteren Leistungshalbleiterchips, werden von der oberen Freilaufdiode durch einen Überschuss an durchgängig injizierten Ladungsträgern hohe Schaltverluste verursachen.

Um dies zu vermeiden, wird vor der Kommutierung des Stroms auf den unteren schaltbaren Leistungshalbleiter des unteren Leistungshalbleiterchips ein sogenannter Entsättigungsimpuls an das Gate von dessen oberen schaltbaren Leistungshalbleiter angelegt. Das Ansteuerpotential am Gate weist im Moment des Entsättigungsimpulses einen deutlich positiven Wert auf, z.B. +15V. Dieser Wert kann einem Gate-Durchlasspotential entsprechen, welches an das Gate von schaltbaren Leistungshalbleitern üblicherweise dann angelegt wird, wenn sich diese in einem sicheren geöffneten Zustand befinden oder befinden sollen. Als sicherer geöffneter Zustand wird im Allgemeinen ein Zustand angenommen, bei dem ein Stromfluss zwischen Collector und Emitter im schaltbaren Leistungshalbleiter zustande kommt oder kommen soll, also die Collector-Emitter-Strecke sehr niederohmig wird oder ist.

Mittels des Entsättigungsimpulses gelingt es, den für die Stromführung in der oberen Freilaufdiode des oberen Leistungshalbleiterchips aufgebauten Überschusses an Ladungsträgern, vorbereitend für die Kommutierung des Stromes auf den unteren schaltbaren Leistungshalbleiter des unteren Leistungshalbleiterchips, zumindest abzubauen und somit Schaltverluste während des Kommutierungsvorgangs zu begrenzen.

Vor dem Öffnen des unteren schaltbaren Leistungshalbleiters, und somit vor der Übergabe des Stroms, wird der obere schaltbare Leistungshalbleiter jedoch wieder durch das Anlegen eines deutlich negativeren Gate-Ansteuerpotentials, welches üblicherweise wieder dem Gate-Ansteuerpotential während der stromführenden Phase der oberen Freilaufdiode entspricht, z.B. -15V, gesperrt werden, um einen Kurzschluss im Brückenzweig der Brückenschaltung zu verhindern.

Im Zeitraum nach dem Entsättigungsimpuls und vor dem Öffnen des unteren schaltbaren Leistungshalbleiters werden dadurch jedoch Ladungsträger wieder verstärkt und unerwünscht in die obere Freilaufdiode des oberen Leistungshalbleiterchips injiziert, was doch wiederum Schaltverluste während des Kommutierungsvorgangs in einem unerwünschten Ausmaß erzeugt. Der genannte Zeitraum könnte weiter verringert werden, wobei dieser aber nicht beliebig klein werden kann, da bisherige Ansteuerverfahren bauteilabhängig genügend Zeit für die Sperrung des oberen schaltbaren Leistungshalbleiters lassen müssen.

Leistungshalbleiterchips mit schaltbaren Leistungshalbleitern, welche exakt spezifizierte Laufzeiten für deren im Kontext erläuterte Sperrung aufweisen, sowie Ansteuerschaltungen für derartige Leistungshalbleiterchips mit exakt spezifizierter Laufzeit sind bisher im Allgemeinen sehr teuer und daher aus wirtschaftlicher Sicht nur bedingt einsetzbar.

Eine weitere Möglichkeit, um die beschriebenen Schaltverluste im genannten Zeitraum gering zu halten, zeigt auf, dass das Ansteuerpotential für die Sperrung des oberen schaltbaren Leistungshalbleiters vor der Kommutierung des Stroms der oberen Freilaufdiode auf den unteren schaltbaren Leistungshalbleiter mit einem Wert von beispielsweise 0V belegt wird, welcher deutlich positiver ist, als das Gate-Sperrpotential von beispielsweise -15V, aber auch deutlich negativer ist, als das Gate-Durchlasspotential von beispielsweise +15V.

Damit werden für den Zeitraum der Sperrung des oberen schaltbaren Leistungshalbleiters nach dem Entsättigungsimpuls einerseits weniger Ladungsträger in die obere Freilaufdiode des oberen Leistungshalbleiterchips injiziert, was die Schaltverluste weiter reduziert.

Jedoch werden mit allen bisher bekannten Lösungen immer noch erhebliche Mengen an Ladungsträger wieder in die zur Beschreibung des technischen Prinzips beispielhaft ausgewählte obere Freilaufdiode injiziert, somit weiterhin unerwünschte Schaltverluste während des Kommutierungsvorgangs in einem für viele Anwendungen der Leistungshalbleiterchips nicht vernachlässigbarem Ausmaß erzeugt.

Der Erfindung liegt die Aufgabe zugrunde, ein Ansteuerverfahren und eine Vorrichtung zur Durchführung des Verfahrens bereitzustellen, welche die von einer Freilaufdiode in Verbindung mit einem schaltbaren Leistungshalbleiter in Leistungshalbleiterchips erzeugten Schaltverluste während einer Kommutierung eines Stroms in einem Brückenzweig einer Brückenschaltung im Vergleich zum Stand der Technik weiter reduziert, ohne die Funktionsfähigkeit der Leistungshalbleiterchips zu gefährden und/ oder deren Lebensdauer zu reduzieren.

Der Erfindung liegt die Erkenntnis zugrunde, dass der beschriebene Vorgang einer Kommutierung des Stroms im Brückenzweig einer Brückenschaltung potentielle Möglichkeiten bietet, die Schaltverluste einer gemeinsam mit einem schaltbaren Leistungshalbleiter in einen Leistungshalbleiterchip integrierte Freilaufdiode signifikant zu reduzieren. Als von besonderer Bedeutung für die Erfindung identifiziert wurde dabei der Zeitraum zwischen dem Ende des Entsättigungsimpulses zum Abbau der Ladungsträger in der Freilaufdiode und der Kommutierung des Stroms auf den übernehmenden schaltbaren Leistungshalbleiter. Die Erfindung berücksichtigt darüber hinaus, dass sich die Funktionalität der Leistungshalbleiterchips, insbesondere die Leitfähigkeit der Freilaufdiode während ihres funktional erwarteten Leitzustands nicht in Bezug auf bisher bekannte Lösungen verschlechtern darf.

Die Aufgabe wird durch ein Ansteuerverfahren mit den in Patentanspruch 1 angegebenen Verfahrensschritten gelöst. Ferner wird die Aufgabe durch eine Vorrichtung zur Durchführung des Ansteuerverfahrens mit den in Patentanspruch 8 angegebenen Merkmalen sowie durch einen Umrichter mit den in Patentanspruch 14 angegebenen Merkmalen gelöst.

Bei einem erfindungsgemäßen Ansteuerverfahren für einen ersten Leistungshalbleiterchip mit einem ersten schaltbaren Leistungshalbleiter und einer ersten Freilaufdiode und für einen zweiten Leistungshalbleiterchip mit einem zweiten schaltbaren Leistungshalbleiter und einer zweiten Freilaufdiode in einem Brückenzweig einer Brückenschaltung zur Kommutierung eines Phasenstroms, liegt bis zu einem ersten Zeitpunkt an einem ersten Gate des ersten schaltbaren Leistungshalbleiters ein erstes negatives Ansteuerpotential an und die erste Freilaufdiode führt einen ersten Diodenstrom als Phasenstrom. Bis zu diesem ersten Zeitpunkt, noch vor Beginn der Kommutierung des Phasenstroms vom ersten Leistungshalbleiterchip zum zweiten Leistungshalbleiterchip im Brückenzweig der Brückenschaltung, ist der erste schaltbare Leistungshalbleiter abgeschaltet. Die erste Freilaufdiode ist jedoch besonders leitfähig, da sie den Phasenstrom alleinig führt. Der zweite schaltbare Leistungshalbleiter befindet sich ebenfalls noch in einem abgeschalteten Zustand, die zweite Freilaufdiode sperrt.

In einem weiteren erfindungsgemäßen Verfahrensschritt des erfindungsgemäßen Ansteuerverfahrens wird ab dem ersten Zeitpunkt der erste schaltbare Leistungshalbleiter mittels eines an seinem ersten Gate anliegenden ersten positiven Ansteuerpotentials eingeschaltet. Mit dem ersten positiven Ansteuerpotential wird ein Entsättigungsimpuls an das erste Gate des ersten schaltbaren Leistungshalbleiters gegeben, wobei Ladungsträger aus der ersten Freilaufdiode ausgeräumt werden, was deren Leitfähigkeit vorteilhaft reduziert.

In einem weiteren erfindungsgemäßen Verfahrensschritt wird zu einem nach dem ersten Zeitpunkt folgenden zweiten Zeitpunkt der zweite schaltbare Leistungshalbleiter mittels eines an seinem zweiten Gate durchgeführten Potentialwechsels von einem dritten negativen Ansteuerpotential auf ein zweites positives Ansteuerpotential eingeschaltet, so dass beide schaltbare Leistungshalbleiter eingeschaltet sind. Vorteilhaft ist, dass der erste schaltbare Leistungshalbleiter mit Einschalten des zweiten schaltbaren Leistungshalbleiters ebenfalls noch eingeschaltet ist. Dies verhindert, dass vor dem Einschalten des zweiten schaltbaren Leistungshalbleiters wieder Ladungsträger in die erste Freilaufdiode injiziert werden können, worauf Schaltverluste während der Kommutierung im Vergleich zu bisher bekannten Lösungen signifikant weiter verringert werden. Mit eingeschaltetem zweitem schaltbarem Leistungshalbleiter beginnt die Kommutierung des bis dahin als Diodenstrom über die erste Freilaufdiode geführten Phasenstroms von der ersten Freilaufdiode des ersten Leistungshalbleiterchips auf den zweiten schaltbaren Leistungshalbleiter des zweiten Leistungshalbleiterchips. Der erste Diodenstrom reduziert sich unmittelbar mit eingeschaltetem zweitem Leistungshalbleiter, da der zweite schaltbare Leistungshalbleiter bis zu einer vollständigen Übernahme des Phasenstroms diesen zunehmend führt.

Um nun unzulässig hohe Ströme durch die eingeschalteten zwei schaltbaren Leistungshalbleiter mittels eines Brückenkurzschlusses im Brückenzweig zu verhindern, erfolgt erfindungsgemäß daraufhin eine Auswertung des ersten Diodenstroms der ersten Freilaufdiode des ersten schaltbaren Leistungshalbleiters, wobei bei Vorliegen einer Stromreduzierung des ersten Diodenstroms zu einem nach dem zweiten Zeitpunkt folgenden dritten Zeitpunkt der erste schaltbare Leistungshalbleiter mittels eines an seinem ersten Gate anliegenden zweiten negativen Ansteuerpotentials abgeschaltet wird. Da die Ansteuerpotentiale für die beiden schaltbaren Leistungshalbleiter elektrisch getrennt sind, kann beispielsweise der am zweiten Gate des zweiten schaltbaren Leistungshalbleiters durchgeführte Potentialwechsel von dem dritten negativen Ansteuerpotential auf das zweite positive Ansteuerpotential zum Einschalten des zweiten schaltbaren Leistungshalbleiters nicht gleichzeitig als Ansteuerpotential genutzt werden, um den ersten schaltbaren Leistungshalbleiter faktisch zeitgleich abzuschalten.

Die Erfindung ist nun dahingehend besonders vorteilhaft, dass mit Auswertung des ersten Diodenstroms und bei Vorliegen der Stromreduzierung der erste schaltbare Leistungshalbleiter rechtzeitig abgeschaltet wird, ohne dass sich unzulässig hohe Ströme in den beiden Leistungshalbleiterchips im Brückenzweig der Brückenschaltung bilden.

Vorteilhafte Ausgestaltungsformen des Ansteuerverfahrens sind in den abhängigen Ansprüchen angegeben.

Bei einer ersten vorteilhaften Ausgestaltungsform des erfindungsgemäßen Ansteuerverfahrens wird die Stromreduzierung des ersten Diodenstroms mittels eines ersten Spannungsabfalls über einer ersten Induktivität ermittelt, welche einen elektrischen Leiter an einem ersten Emitter des ersten schaltbaren Leistungshalbleiters aufweist. Vorteilhaft wird hier zur Erkennung der Stromreduzierung ein physikalischer Effekt ausgenutzt, welcher darin besteht, dass sich der erste Spannungsabfall über der ersten Induktivität proportional zu der Stromreduzierung des ersten Diodenstroms verhält. Der erste Spannungsabfall wird mit Beginn der Stromreduzierung bzw. einer Stromänderung über der ersten Induktivität erzeugt und impliziert somit die Stromreduzierung. Für die Nutzung des physikalischen Effekts ist die erste Induktivität in dem elektrischen Leiter ausreichend, welche mit dem ersten Emitter des ersten schaltbaren Leistungshalbleiters am ersten Leistungshalbleiterchip elektrisch verbunden ist.

Bei einer weiteren vorteilhaften Ausgestaltungsform wird der erste Spannungsabfall durch eine erste Spannungserfassungsvorrichtung ermittelt, welche mittels elektrischer Anschlüsse mit dem ersten Emitter und einem ersten Hilfsemitter des ersten schaltbaren Leistungshalbleiters elektrisch verbunden ist. Der erste Spannungsabfall verhält sich proportional zur Stromreduzierung des ersten Diodenstroms. Da sich die Stromreduzierung des ersten Diodenstroms messtechnisch als Strom nur aufwendig im oder am ersten Leistungshalbleiterchip ermitteln lässt, wird mittels der ersten Spannungserfassungsvorrichtung in vorteilhafter Weise der erste Spannungsabfall über der ersten Induktivität ermittelt.

Bei einer weiteren vorteilhaften Ausgestaltungsform wird das zweite negative Ansteuerpotential an das erste Gate des ersten schaltbaren Leistungshalbleiters zum Abschalten dann angelegt, wenn die erste Freilaufdiode des ersten schaltbaren Leistungshalbleiters den ersten Diodenstrom führt und der erste Spannungsabfall über der ersten Induktivität ermittelt ist. Wie schon beschrieben wird zur Erkennung der Stromreduzierung vorteilhaft ein physikalischer Effekt ausgenutzt, welcher aufzeigt, dass sich der erste Spannungsabfall über der ersten Induktivität proportional zu der Stromreduzierung des ersten Diodenstroms verhält. Erst wenn der erste Spannungsabfall über der ersten Induktivität als Folge der Stromreduzierung ermittelt wurde, also beispielsweise beim Auftreten einer negativen Spannungsänderung, erfolgt die Abschaltung des ersten schaltbaren Leistungshalbleiters.

Ein Auftreten des ersten Spannungsabfalls ist daher ein Signal dafür, dass der zweite schaltbare Leistungshalbleiter eingeschaltet wurde. Die Abschaltung des ersten schaltbaren Leistungshalbleiters erfolgt daraufhin unverzüglich unter Berücksichtigung möglicher Totzeiten, bevor sich im Brückenzweig der Brückenschaltung zwischen den beiden schaltbaren Leistungshalbleitern der Leistungshalbleiterchip der unzulässig hohen Strom aufgrund des Brückenkurzschlusses aufbaut, und in Folge die Leistungshalbleiterchips sowie weitere elektrische Bauteile zumindest in der Brückenschaltung zerstören kann.

Bei einer weiteren vorteilhaften Ausgestaltungsform wird insbesondere das zweite negative Ansteuerpotential zum Abschalten des ersten schaltbaren Leistungshalbleiters über einen ersten niederohmigen Gate-Widerstand als separaten Gate-Widerstand einer ersten Treibervorrichtung mittels einer ersten separaten Gate-Ansteuerleitung an das erste Gate des ersten schaltbaren Leistungshalbleiters geführt. Ein niederohmiger Widerstand ist ein Widerstand, dessen Widerstandswert üblicherweise kleiner oder gleich wenige Ohm, z.B. 10Ω beträgt. Der erste niederohmige Gate-Widerstand der ersten Treibervorrichtung stellt vorteilhaft sicher, dass der erste schaltbare Leistungshalbleiter mittels des zweiten negativen Ansteuerpotentials während der Kommutierung schneller abgeschaltet werden kann, als es Abschaltvorgänge des ersten schaltbaren Leistungshalbleiters außerhalb der beschriebenen Kommutierung erfordern.

Die erste separate Gate-Ansteuerleitung führt somit insbesondere das zweite negative Ansteuerpotential zum Abschalten des ersten schaltbaren Leistungshalbleiters an dessen erstes Gate, was jedoch nicht ausschließt, dass weitere Ansteuerpotentiale für den ersten schaltbaren Leistungshalbleiter ebenfalls über den separaten Gate-Widerstand der ersten Treiberschaltung und die erste separate Gate-Ansteuerleitung geführt werden können.

Bei einer weiteren vorteilhaften Ausgestaltungsform wird das zweite negative Ansteuerpotential zum dritten Zeitpunkt an das erste Gate des ersten schaltbaren Leistungshalbleiters zu dessen Abschaltung angelegt, bevor der erste Diodenstrom zu einem vierten Zeitpunkt einen Wert Null erreicht oder genau dann, wenn der erste Diodenstrom zu einem vierten Zeitpunkt einen Wert Null erreicht. Erfolgt die Abschaltung des ersten schaltbaren Leistungshalbleiters nicht vor dem vierten Zeitpunkt oder spätestens zum vierten Zeitpunkt, kann sich der erste Diodenstrom beispielsweise nach einem Nulldurchgang von einem positiven Stromwert kommend zu einem negativen Stromwert aufbauen. Dies verursacht unerwünschte elektrische Verluste im ersten schaltbaren Leistungshalbleiter. Der erste schaltbare Leistungshalbleiter wird daher in vorteilhafter Weise vor oder auch mit dem Nulldurchgang des ersten Diodenstroms abgeschaltet.

Bei einer weiteren vorteilhaften Ausgestaltungsform wird das Ansteuerverfahren lediglich durchgeführt, wenn der mittels einer Phasenstromerfassungsvorrichtung ermittelte Phasenstrom einer Wechselstromphase größer ist als ein Stromgrenzwert.

Ist der Phasenstrom zu gering, beispielsweise bei einem sinkenden Laststrom, steigt die Anforderung an eine Reaktionsgeschwindigkeit insbesondere für die Abschaltung des ersten schaltbaren Leistungshalbleiters. Erfolgt die Abschaltung des ersten schaltbaren Leistungshalbleiters nicht vor dem Nulldurchgang des ersten Diodenstroms, kann der erste Diodenstrom nach dem Nulldurchgang einen unerwünscht hohen Wert annehmen. Da bei geringem Phasenstrom bzw. sinkendem Laststrom Schaltverluste der schaltbaren Leistungshalbleiter eher vernachlässigbar sind, wird das Ansteuerverfahren in vorteilhafter Weise nur dann durchgeführt, wenn der Phasenstrom über dem Stromgrenzwert liegt.

Für die Lösung der Aufgabe wird ebenfalls eine Vorrichtung zur Durchführung eines erfindungsgemäßen Ansteuerverfahrens vorgeschlagen, welche mindestens zwei Leistungshalbleiterchips in einem Brückenzweig einer Brückenschaltung, einen ersten schaltbaren Leistungshalbleiter mit einer ersten Freilaufdiode im ersten Leistungshalbleiterchip, einen zweiten schaltbaren Leistungshalbleiter mit einer zweiten Freilaufdiode im zweiten Leistungshalbleiterchip, eine erste Treibervorrichtung und eine zweite Treibervorrichtung, sowie mindestens eine Recheneinheit aufweist.

Mittels der ersten Treibervorrichtung ist bis zu einem ersten Zeitpunkt an das erste Gate des ersten schaltbaren Leistungshalbleiters ein erstes negatives Ansteuerpotential anlegbar und ein erster Diodenstrom kann als Phasenstrom durch die erste Freilaufdiode geführt werden.

Mittels der ersten Treibervorrichtung ist zu einem ersten Zeitpunkt an das erste Gate des ersten schaltbaren Leistungshalbleiters ein positives Ansteuerpotential anlegbar und der erste schaltbare Leistungshalbleiter kann eingeschaltet werden.

Mittels der zweiten Treibervorrichtung ist zu einem zweiten Zeitpunkt an dem zweiten Gate des zweiten schaltbaren Leistungshalbleiters ein Potentialwechsel von einem dritten negativen Ansteuerpotential auf ein zweites positives Ansteuerpotential durchführbar und der zweite schaltbare Leistungshalbleiter kann eingeschaltet werden.

Mittels der mindestens einen Recheneinheit kann eine Auswertung des ersten Diodenstroms der ersten Freilaufdiode des ersten schaltbaren Leistungshalbleiters durchgeführt werden.

An die erste Treibervorrichtung ist auf Basis der Auswertung des ersten Diodenstroms bei Vorliegen einer Stromreduzierung zu einem dritten Zeitpunkt an das erste Gate des ersten schaltbare Leistungshalbleiters ein zweites negatives Ansteuerpotential anlegbar und der erste schaltbare Leistungshalbleiter kann abgeschaltet werden.

Eine erste vorteilhafte Ausgestaltungsform der Vorrichtung zur Durchführung des erfindungsgemäßen Ansteuerverfahrens weist einen elektrischen Leiter mit einer ersten Induktivität an einem ersten Emitter des ersten schaltbaren Leistungshalbleiters auf, wobei die Stromreduzierung des ersten Diodenstroms mittels eines ersten Spannungsabfalls über der ersten Induktivität ermittelbar ist.

Zur Erkennung der Stromreduzierung wird vorteilhaft ein physikalischer Effekt ausgenutzt, bei dem sich der erste Spannungsabfall über der ersten Induktivität proportional zu der Stromreduzierung des ersten Diodenstroms verhält. Der erste Spannungsabfall ist mit Beginn der Stromreduzierung über der ersten Induktivität erzeugbar und impliziert somit die Stromreduzierung. Für die Nutzung des physikalischen Effekts ist eine Leitungsinduktivität des elektrischen Leiters als erste Induktivität ausreichend.

Eine weitere vorteilhafte Ausgestaltungsform der Vorrichtung weist eine erste Spannungserfassungsvorrichtung auf, mittels der der erste Spannungsabfall über der ersten Induktivität in dem elektrischen Leiter ermittelbar ist, und wobei die erste Spannungserfassungsvorrichtung mittels elektrischer Anschlüsse mit dem ersten Emitter und einem ersten Hilfsemitter des ersten schaltbaren Leistungshalbleiters elektrisch verbunden ist.

Besonders vorteilhaft kann die erste Spannungserfassungsvorrichtung mittels der elektrischen Anschlüsse mit dem ersten Emitter und dem ersten Hilfsemitter verbunden werden. Ein Bonddraht mit der ersten Induktivität zwischen dem ersten Emitter und dem ersten Hilfsemitter des ersten schaltbaren Leistungshalbleiters kann ebenfalls den elektrischen Leiter bilden.

Eine weitere vorteilhafte Ausgestaltungsform der Vorrichtung weist einen ersten niederohmigen Gate-Widerstand als separaten Gate-Widerstand der ersten Treibervorrichtung und eine erste separate Gate-Ansteuerleitung zwischen dem ersten niederohmigen Gate-Widerstand und dem ersten Gate des ersten schaltbaren Leistungshalbleiters auf, über dem insbesondere das zweite negative Ansteuerpotential zum Abschalten des ersten schaltbaren Leistungshalbleiters an das erste Gate des ersten schaltbaren Leistungshalbleiters führbar ist.

Ein niederohmiger Widerstand ist ein Widerstand, dessen Widerstandswert üblicherweise kleiner gleich wenige Ohm, z.B. 10Ω beträgt. Der erste niederohmige Gate-Widerstand als separater Gate-Widerstand der ersten Treibervorrichtung stellt vorteilhaft sicher, dass der erste schaltbare Leistungshalbleiter mittels des zweiten negativen Abschaltpotentials für einen Abschaltvorgang während der Kommutierung schneller abgeschaltet werden kann, als es weitere Abschaltvorgänge des ersten schaltbaren Leistungshalbleiters außerhalb der beschriebenen Kommutierung erfordern.

Eine weitere vorteilhafte Ausgestaltungsform der Vorrichtung weist eine Phasenstromerfassungsvorrichtung zur Ermittlung eines Phasenstroms in einer Wechselstromphase und ein Mittel zur Festlegung eines Stromgrenzwerts für einen Vergleich des Phasenstroms mit dem Stromgrenzwert auf.

Da das erfindungsgemäße Ansteuerverfahren bei Kommutierung des Phasenstroms von der zweiten Freilaufdiode des zweiten Leistungshalbleiterchips auf den ersten schaltbaren Leistungshalbleiter des ersten Leistungshalbleiterchips invers zur Kommutierung des Phasenstroms von der ersten Freilaufdiode des ersten Leistungshalbleiterchips auf den zweiten schaltbaren Leistungshalbleiter des zweiten Leistungshalbleiterchips verläuft, kann es notwendig werden, für die Vorrichtung eine zweite Recheneinheit vorzusehen, um diese ohne Potenzialtrennung mit der Spannungserfassungseinheit und der Treibervorrichtung für den Leistungshalbleiter T2, T zu verbinden.

Auch wenn die Ermittlung des Phasenstroms mittels der Potenzialtrennung längere Verzugszeiten enthält, ist das in diesem Fall akzeptabel, da sich die Höhe des Phasenstromes nur langsam ändert und für die jeweils betrachtete Kommutierung des Phasenstroms während des Ansteuerverfahrens als konstant angenommen werden kann, so dass die Phasenstrommessung zeitlich auch vor dem Kommutierungszeitraum liegen kann. Die Potenzialtrennung für den ermittelten Phasenstrom ist jedoch in der Regel kein Zusatzaufwand, da dieser für eine Regelung eines Stromrichters ohnehin benötigt wird.

Ein zweiter Stromgrenzwert für die zweite Recheneinheit würde einen gleichen Betrag aufweisen wie für den Stromgrenzwert für die mindestens eine Recheneinheit, jedoch mit einem invertierten Vorzeichen. Der Vergleich verläuft dann in inverser Richtung ab.

Bei einer weiteren vorteilhaften Ausgestaltungsform der Vorrichtung sind die Leistungshalbleiterchips als Reverse Conducting Diode-Controlled Insulated-Gate Bipolare Transistors (RCDC-IGBT) ausgebildet.

Für die Lösung der Aufgabe wird weiterhin ein Umrichter mit einer erfindungsgemäßen Vorrichtung vorgeschlagen, welcher einen Gleichspannungszwischenkreis mit einer ersten Gleichstromphase und einer zweiten Gleichstromphase aufweist, und weiterhin ein Wechselstromsystem mit mindesten zwei Wechselstromphasen zum jeweiligen Führen eines Phasenstroms aufweist, wobei ein Brückenzweig einer Brückenschaltung mit mindestens zwei Leistungshalbleiterchips mittels eines Gleichstromanschlusses mit der ersten und der zweiten Gleichstromphase des Gleichspannungszwischenkreises und mittels eines Wechselstromanschlusses mit jeweils einer der Wechselstromphasen des Wechselstromsystems verbunden ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine erste schematische Darstellung einer Vorrichtung zur Durchführung eines erfindungsgemäßen Ansteuerverfahren mit einem Brückenzweig in einer als Halbbrückenschaltung ausgebildeten Brückenschaltung zur Kommutierung eines Phasenstroms von einer ersten Freilaufdiode eines ersten Leistungshalbleiterchips auf einen zweiten schaltbaren Leistungshalbleiter eines zweiten Leistungshalbleiterchips,
- FIG 2: vier zusammengehörende Diagramme a, b, c, d eines erfindungsgemäßen Ansteuerverfahrens zur Kommutierung des Phasenstroms im Brückenzweig einer Brückenschaltung nach FIG 1,
- FIG 3: ein Struktogramm mit wesentlichen Schritten des erfindungsgemäßen Ansteuerverfahrens nach FIG 2, und
- FIG 4: eine schematische Darstellung eines Umrichters mit einer als Sechspuls-Brückenschaltung ausgebildeten Brückenschaltung und mit jeweils einer Vorrichtung nach FIG 1 pro Brückenzweig der Brückenschaltung.

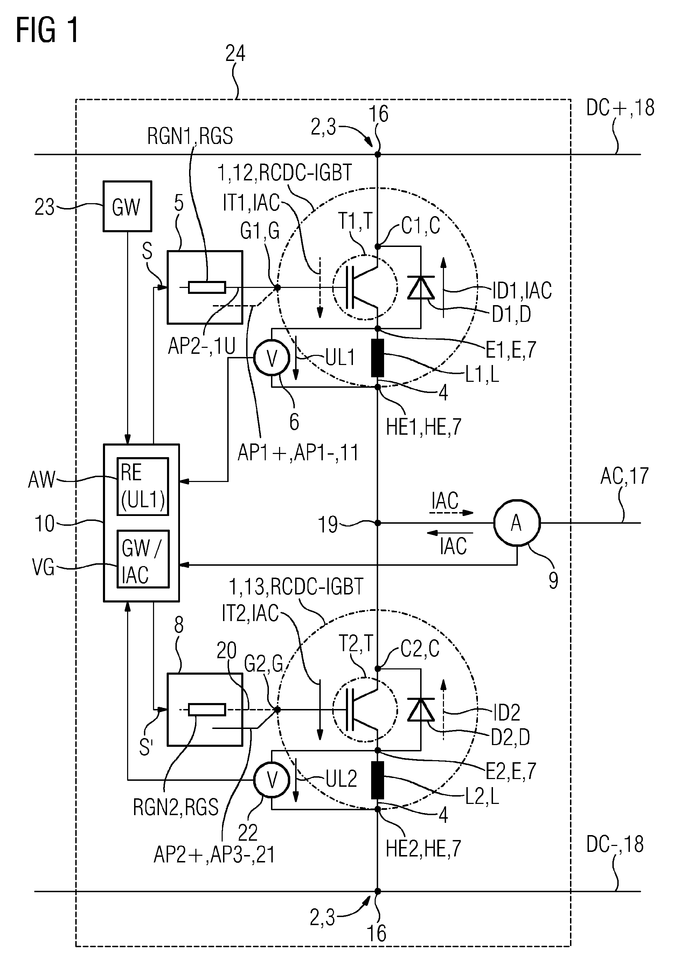

FIG 1 zeigt ein Beispiel für eine Vorrichtung 24 zur Durchführung eines erfindungsgemäßen Ansteuerverfahren mit einem Brückenzweig 2 in einer als Halbbrückenschaltung ausgebildeten Brückenschaltung 3 zur Kommutierung eines Phasenstroms IAC von einer ersten Freilaufdiode D1, D eines ersten Leistungshalbleiterchips 1, 12 auf einen zweiten schaltbaren Leistungshalbleiter T2, T eines zweiten Leistungshalbleiterchips 1, 13.

In dem Brückenzweig 2 ist ein erster schaltbarer Leistungshalbleiter T1, T des ersten Leistungshalbleiterchips 1, 12 mit seinem ersten Collector C1, C über einen Gleichstromanschluss 16 mit einer ersten Gleichstromphase DC+ eines Gleichspannungszwischenkreises 18 verbunden. Der zweite schaltbare Leistungshalbleiter T2, T des zweiten Leistungshalbleiterchips 1, 13 ist mit seinem zweiten Emitter E2, E über den Gleichstromanschluss 16 mit einer zweiten Gleichstromphase DC- eines Gleichspannungszwischenkreises 18 verbunden. Ferner ist der erste schaltbare Leistungshalbleiter T1, T mit seinem ersten Emitter E1, E und der zweite schaltbare Leistungshalbleiter T2, T mit seinem zweiten Collector C2, C über einen Wechselstromanschluss 19 mit einer Wechselstromphase AC eines Wechselstromsystems 17 verbunden.

Die erste Freilaufdiode D1, D ist mit dem ersten schaltbaren Leistungshalbleiter T1, T und die zweite Freilaufdiode D2, D ist mit dem zweiten schaltbaren Leistungshalbleiter T2, T jeweils antiparallel verschaltet.

Sowohl der Gleichspannungszwischenkreis 18 wie auch das Wechselstromsystem 17 sind in FIG 1 nur angedeutet. Der Gleichspannungszwischenkreis 18 kann beispielsweise Teil eines Frequenzumrichters sein. Die Wechselstromphase AC ist Teil des Wechselstromsystems, welches zweiphasig oder dreiphasig ausgebildet sein kann.

Beide schaltbaren Leistungshalbleiter T1, T2, T werden über ihre jeweiligen Gates G1, G2, G mittels entsprechender Ansteuerpotentiale AP1-, AP2-, AP3-, AP1+, AP2+ angesteuert, wobei die schaltbaren Leistungshalbleiter T1, T2, T die jeweiligen Freilaufdioden D1, D2, D in ihrer Leitfähigkeit beeinflussen.

Die Kommutierung des Phasenstroms IAC im Brückenzweig 2 der Brückenschaltung 3 wird im Folgenden ausgehend von der Wechselstromphase AC des Wechselspannungskreises 16 bis in die Gleichstromphasen DC+, DC- des Gleichspannungszwischenkreises 18 betrachtet.

Bei einem ersten Kommutierungsvorgang fließt vor der Kommutierung der Phasenstrom IAC als erster Diodenstrom ID1 über die erste Freilaufdiode D1, D, des ersten Leistungshalbleiterchips 1, 12 in die erste Gleichstromphase DC+ des Gleichspannungszwischenkreises 18. Der erste schaltbare Leistungshalbleiter T1, T des ersten Leistungshalbleiterchips 1, 12 und der zweite schaltbare Leistungshalbleiter T2, T des zweiten Leistungshalbleiterchips 1, 13 sind abgeschaltet, die zweite Freilaufdiode des zweiten Leistungshalbleiterchips 1, 13 ist gesperrt.

Während der Kommutierung erfolgt eine Ansteuerung des ersten Gates G1, G des ersten schaltbaren Leistungshalbleiters T1, T durch Ansteuerpotentiale AP1-, AP1+, AP2-, wobei ein zweites negatives Ansteuerpotential AP2- zur Abschaltung des ersten schaltbaren Leistungshalbleiters T1, T insbesondere über einen ersten niederohmigen Gate-Widerstand RGN1 als separaten Widerstand einer ersten Treibervorrichtung 5 mittels einer ersten separaten Gate-Ansteuerleitung 14 an das erste Gate G1, G angelegt wird. Ein erstes negatives Ansteuerpotential AP1- sowie ein erstes positives Ansteuerpotential AP1+ werden insbesondere über eine erste Gate-Ansteuerleitung 11 an das erste Gate G1, G angelegt. Ferner erfolgt eine Ansteuerung des zweiten Gates G2, G des zweiten schaltbaren Leistungshalbleiters T2, T durch ein zweites positives Ansteuerpotential AP2+ und ein drittes negatives Ansteuerpotential AP3-ausgehend von einer zweiten Treibervorrichtung 8 insbesondere mittels einer zweiten Gate-Ansteuerleitung 21.

Mittels einer ersten Spannungserfassungsvorrichtung 6 wird ein erster Spannungsabfall UL1 über einer ersten Induktivität L1, L einer elektrischen Leitung 4 ermittelt, welche mit einem ersten Emitter E1, E und einem ersten Hilfsemitter EH1, EH des ersten Leitungshalbleiterchips 1, 12 durch elektrische Anschlüsse 7 verbunden sind.

Der Phasenstrom IAC wird mittels einer Phasenstromerfassungsvorrichtung 9 ermittelt. Sowohl der ermittelte erste Spannungsabfall UL1 wie auch der ermittelte Phasenstrom IAC werden als Spannungs- bzw. Stromwerte an mindestens eine Recheneinheit 10 übermittelt.

Die mindestens eine Recheneinheit 10 weist eine Auswertung auf, welche den ersten Diodenstrom ID1 mittels des ersten Spannungsabfalls UL1 auf eine Stromreduzierung RE hin auswertet. Weiterhin weist die mindestens eine Recheneinheit 10 einen Vergleich VG auf, welcher einen Stromgrenzwert GW mit dem ermittelten Phasenstrom IAC vergleicht. Der Stromgrenzwert wird mit einem Mittel 23, zum Beispiel einem Eingabemittel, festgelegt, wobei das Mittel 23 mit der mindestens einen Recheneinheit 10 verbunden ist.

Die mindestens eine Recheneinheit 10 erzeugt Schaltsignale S, S' und übermittelt diese an die mit ihr verbundenen jeweiligen Treibervorrichtungen 5, 8, welche die Schaltsignale S, S' in Ansteuerpotentiale AP1-, AP1+, AP2-, AP2+, AP3- zur Ansteuerung der jeweiligen schaltbaren Leistungshalbleiter T1, T2, T umwandeln.

Ist die Kommutierung abgeschlossen, fließt dann der Phasenstrom IAC als zweiter Transistorstrom IT2 über den zweiten schaltbaren Leistungshalbleiter T2, T des zweiten Leistungshalbleiterchips 1, 13 in die zweite Gleichstromphase DC- des Gleichspannungszwischenkreises 18, wobei die zweite Freilaufdiode D2, D des zweiten Leistungshalbleiterchips 1, 13 weiterhin gesperrt ist. Eine Übergabe des Phasenstroms IAC von der ersten Freilaufdiode D1 des ersten Leistungshalbleiterchips 1, 12 an den zweiten schaltbaren Leistungshalbleiter T2, T des zweiten Leistungshalbleiterchips 1, 13 hat stattgefunden.

Für einen weiteren Kommutierungsvorgangs findet die Kommutierung des Phasenstrom IAC vergleichbar zur Beschreibung des ersten Kommutierungsvorgangs statt, wobei der Phasenstrom IAC vor Beginn der Kommutierung als zweiter Diodenstrom ID2 über die zweite Freilaufdiode D2, D des zweiten Leistungshalbleiterchips 1, 13 fließt, der Phasenstrom IAC während der Kommutierung an den ersten schaltbaren Leistungshalbleiter T1, T übergeben wird, und nach der Kommutierung der Phasenstrom IAC als ein erster Transistorstrom IT1 in dem ersten schaltbaren Leistungshalbleiter T1, T fließt.

Während des weiteren Kommutierungsvorgangs wird mittels einer zweiten Spannungserfassungsvorrichtung 22 ein zweiter Spannungsabfall UL2 über einer zweiten Induktivität L2, L einer elektrischen Leitung 4 ermittelt, welche mit einem zweiten Emitter E2, E und einem zweiten Hilfsemitter EH2, EH des zweiten Leitungshalbleiterchips 1, 13 durch elektrische Anschlüsse 7 verbunden sind. Die zweite Spannungserfassungsvorrichtung 22 ist mit der mindestens einen Recheneinheit 10 verbunden. Das zweite Gate G2, 2 des zweiten schaltbaren Leistungshalbleiters T2, T ist mittels einer zweiten separaten Gate-Ansteuerleitung 20 mit einem zweiten niederohmigen Gate-Widerstand RGN2 als separaten Gate-Widerstand RGS der zweiten Treibervorrichtung 8 vergleichbar dem ersten Kommutierungsvorgang ansteuerbar.

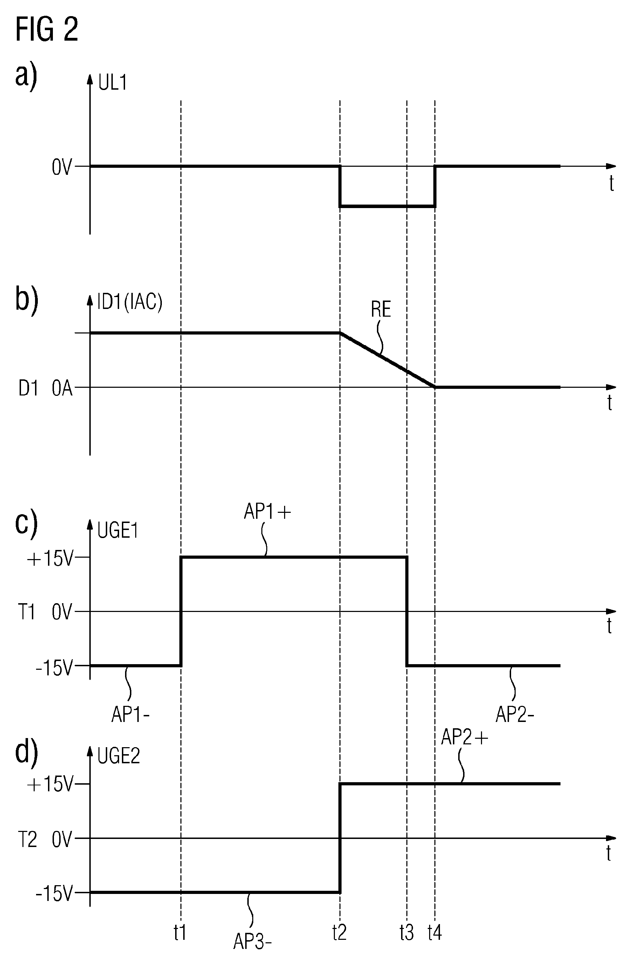

FIG 2 veranschaulicht beispielhaft mittels vier zusammengehöriger Diagramme a, b, c, d ein erfindungsgemäßes Ansteuerverfahren zur Kommutierung des Phasenstroms IAC im Brückenzweig 2 einer Brückenschaltung 3 nach FIG 1. Die Diagramme visualisieren im Wesentlichen eine Ansteuerung eines ersten schaltbaren Leistungshalbleiters T1 eines ersten Leistungshalbleiterchips (in FIG 2 nicht gezeigt) und eines zweiten schaltbaren Leistungshalbleiters T2 eines zweiten Leistungshalbleiterchips (in FIG 2 nicht gezeigt) während eines ersten Kommutierungsvorgangs der Kommutierung des Phasenstroms IAC als ersten Diodenstrom ID1 von der ersten Freilaufdiode D1 auf den zweiten schaltbaren Leistungshalbleiter T2.

Diagramm a zeigt während einer Zeit t einen ersten Spannungsabfall UL1, welcher über einer ersten Induktivität an einem ersten Emitter (in FIG 2 nicht gezeigt) des ersten schaltbaren Leistungshalbleiters T1 auftritt. Diagramm b visualisiert über die Zeit t einen Verlauf des ersten Diodenstroms ID1 als Phasenstrom IAC durch die erste Freilaufdiode D1. Mit dem Diagramm c werden Ansteuerpotentiale AP1-, AP1+, AP2- über die Zeit t aufgezeigt, welche in Form einer ersten Gate-Emitter-Ansteuerspannung UGE1 an ein erstes Gate des ersten schaltbaren Leistungshalbleiters T1 angelegt werden. Mit dem Diagramm d werden über die Zeit t Ansteuerpotentiale AP3-, AP2+ aufgezeigt, welche in Form einer zweiten Gate-Emitter-Ansteuerspannung UGE2 an ein zweites Gate des zweiten schaltbaren Leistungshalbleiters T2 angelegt werden. Zu beiden Diagrammen c und d wurden für die jeweilige Gate-Emitter-Ansteuerspannung beispielhaft Spannungswerte von +15V bzw. -15V gewählt.

Bis zu einem ersten Zeitpunkt t1 liegt am ersten Gate des ersten schaltbaren Leistungshalbleiters T1 ein erstes negatives Ansteuerpotential AP1- und am zweiten Gate des zweiten schaltbaren Leistungshalbleiters T2 ein drittes negatives Ansteuerpotential AP3- an, welches beide schaltbare Leistungshalbleiter T1, T2 abgeschaltet hält. Der erste Diodenstrom ID1 fließt als Phasenstrom IAC durch die erste Freilaufdiode D1. An der Induktivität am ersten Emitter (in FIG 2 nicht gezeigt) des ersten schaltbaren Leistungshalbleiters T1 ist kein erster Spannungsabfall UL1 festzustellen.

Ab dem ersten Zeitpunkt t1 wird an das erste Gate des ersten schaltbaren Leistungshalbleiters T1 ein erstes positives Ansteuerpotential AP1+ angelegt, welches den ersten schaltbaren Leistungshalbleiter T1 einschaltet und so mittels eines Entsättigungsimpulses freie Ladungsträger in der ersten Freilaufdiode reduzieren soll. Am zweiten Gate des zweiten schaltbaren Leistungshalbleiters T2 liegt weiterhin ein drittes negatives Ansteuerpotential AP3- an, der erste Diodenstrom ID1 fliest als Phasenstrom IAC durch die erste Freilaufdiode D1, der erste Spannungsabfall UL1 ist nicht festzustellen.

Zu einem nach dem ersten Zeitpunkt t1 folgenden zweiten Zeitpunkt t2 wird der zweite schaltbare Leistungshalbleiter T2 eingeschaltet, was mittels eines an seinem zweiten Gate durchgeführten Potentialwechsels von einem dritten negativen Ansteuerpotential AP3- auf ein zweites positives Ansteuerpotential AP2+ durchgeführt wird. Beide schaltbare Leistungshalbleiter T1, T2 sind somit zum Zeitpunkt t2 eingeschaltet.

Daraufhin erfolgt eine Auswertung (in FIG 2 nicht gezeigt) des ersten Diodenstroms ID1 der ersten Freilaufdiode D1 des ersten schaltbaren Leistungshalbleiters T1.

Bei Vorliegen einer Stromreduzierung RE des ersten Diodenstroms ID1 zu einem nach dem zweiten Zeitpunkt t2 folgenden dritten Zeitpunkt t3 wird der erste schaltbare Leistungshalbleiter T1 mittels eines an seinem ersten Gate anliegenden zweiten negativen Ansteuerpotentials AP2- abgeschaltet. Ein Aufbau eines unzulässig hohen Stroms in den beiden schaltbaren Leistungshalbleitern T1, T2 aufgrund eines kurzzeitigen Brückenkurzschlusses wird vermieden. Auftretende Schaltverluste in der ersten Freilaufdiode D1 werden im Wesentlichen verhindert oder zumindest stark reduziert, da vor dem Einschalten des zweiten schaltbaren Leistungshalbleiters T2, nach Ausräumen freier Ladungsträger aus der ersten Freilaufdiode D1, keine neuen Ladungsträger in die erste Freilaufdiode D1 injiziert wurden.

Mit Auftreten der Stromreduzierung RE wird über der Induktivität am ersten Emitter (in FIG 2 nicht gezeigt) des ersten schaltbaren Leistungshalbleiters T1 der Spannungsabfall UL1 ermittelt und unter Beachtung von Totzeiten das zweite negative Ansteuerpotential AP2- zum Abschalten des ersten schaltbaren Leistungshalbleiters T1 an dessen erstes Gate (in FIG 2 nicht gezeigt) angelegt.

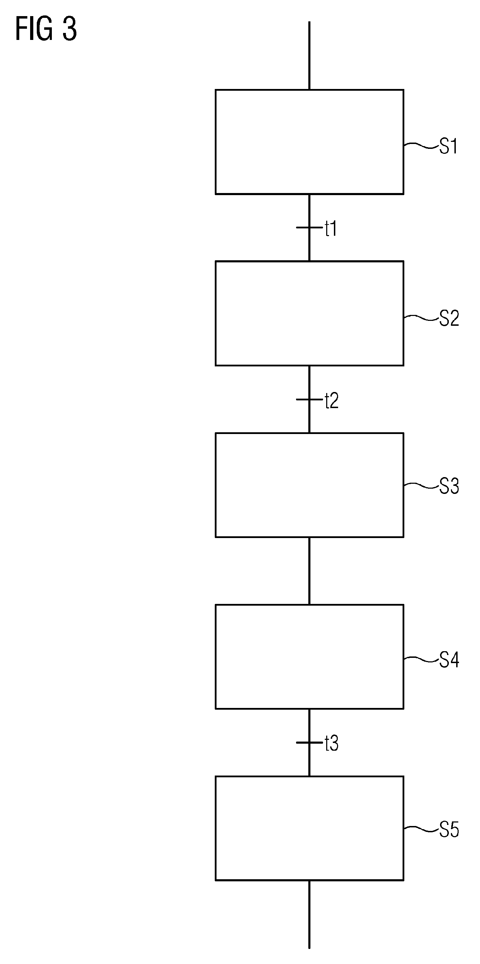

FIG 3 visualisiert beispielhaft mittels eines Struktogramms einige wesentliche Schritte des erfindungsgemäßen Ansteuerverfahrens nach FIG 2.

Im Schritt S1 ist vorgesehen, dass bis zu einem ersten Zeitpunkt t1 an einem ersten Gate des ersten schaltbaren Leistungshalbleiters ein erstes negatives Ansteuerpotential anliegt und die erste Freilaufdiode einen ersten Diodenstrom als Phasenstrom führt.

Ab dem ersten Zeitpunkt t1 wird in einem zweiten Schritt S2 der erste schaltbare Leistungshalbleiter mittels eines an seinem ersten Gate anliegenden ersten positiven Ansteuerpotentials eingeschaltet.

Im Schritt S3 wird zu einem nach dem ersten Zeitpunkt t1 folgenden zweiten Zeitpunkt t2 der zweite schaltbare Leistungshalbleiter, mittels eines an seinem zweiten Gate durchgeführten Potentialwechsels von einem dritten negativen Ansteuerpotential auf ein zweites positives Ansteuerpotential, eingeschaltet, so dass beide schaltbare Leistungshalbleiter eingeschaltet sind.

Mit Schritt S4 erfolgt daraufhin eine Auswertung des ersten Diodenstroms der ersten Freilaufdiode des ersten schaltbaren Leistungshalbleiters.

Im Schritt S5 wird bei Vorliegen einer Stromreduzierung des ersten Diodenstroms zu einem nach dem zweiten Zeitpunkt t2 folgenden dritten Zeitpunkt t3 der erste schaltbare Leistungshalbleiter mittels eines an seinem ersten Gate anliegenden zweiten negativen Ansteuerpotentials abgeschaltet.

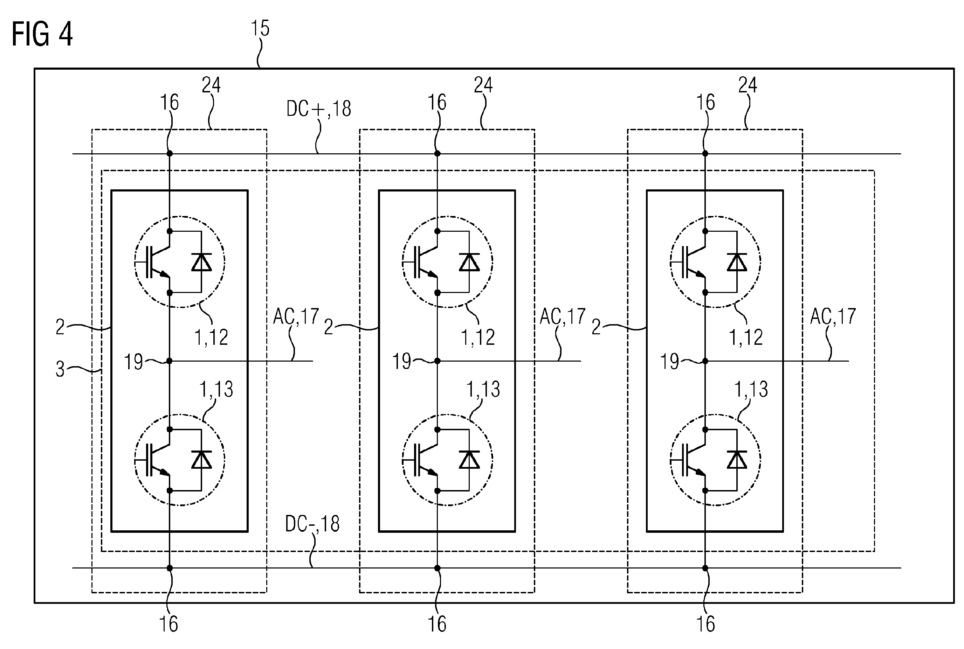

FIG 4 zeigt beispielhaft eine schematische Darstellung eines Umrichters 15 mit einer als Sechspuls-Brückenschaltung ausgebildeten Brückenschaltung 3 und mit pro Brückenzweig 2 der Brückenschaltung 3 jeweils einer Vorrichtung 24 nach FIG 1 zur Durchführung des erfindungsgemäßen Ansteuerverfahrens.

Das Sechspuls-Brückenschaltungsmodul als spezielle Art einer Brückenschaltung 3 besteht aus drei Brückenzweigen 2. Die Vorrichtung 24 ist jeweils einem der Brückenzweige 2 zugeordnet. Der Umrichter 15 weist einen Gleichspannungszwischenkreis 18 mit einer erste Gleichstromphase DC+ und einer zweiten Gleichstromphase DC- auf.

Ferner umfasst der Umrichter 15 ein Wechselstromsystem 17 mit drei Wechselstromphasen AC, welche jeweils den Phasenstrom IAC führen. Ein jeder der Brückenzweige 2 umfasst zwei Leistungshalbleiterchips 1, 12, 13 welche mittels eines Gleichstromanschlusses 16 mit der ersten und der zweiten Gleichstromphase DC+, DC- des Gleichspannungszwischenkreises 18 und mittels eines Wechselstromanschlusses 19 mit jeweils einer der Wechselstromphasen AC des Wechselstromsystems 17 verbunden ist.

## Patentansprüche

1. Ansteuerverfahren für einen ersten Leistungshalbleiterchip (1, 12) mit einem ersten schaltbaren Leistungshalbleiter (T1, T) und einer ersten Freilaufdiode (D1, D) und für einen zweiten Leistungshalbleiterchip (1, 13) mit einem zweiten schaltbaren Leistungshalbleiter (T2, T) und einer zweiten Freilaufdiode (D2, D) in einem Brückenzweig (2) einer Brückenschaltung (3) zur Kommutierung eines Phasenstroms (IAC), wobei
- bis zu einem ersten Zeitpunkt (t1) an einem ersten Gate (G1, G) des ersten schaltbaren Leistungshalbleiters (T1, T) ein erstes negatives Ansteuerpotential (AP1-) anliegt und die erste Freilaufdiode (D1, D) einen ersten Diodenstrom (ID1) als Phasenstrom (IAC) führt,
- ab dem ersten Zeitpunkt (t1) der erste schaltbare Leistungshalbleiter (T1, T) mittels eines an seinem ersten Gate (G1, G) anliegenden ersten positiven Ansteuerpotentials (AP1+) eingeschaltet wird,
- zu einem nach dem ersten Zeitpunkt (t1) folgenden zweiten Zeitpunkt (t2) der zweite schaltbare Leistungshalbleiter (T2, T), mittels eines an seinem zweiten Gate (G2, G) durchgeführten Potentialwechsels von einem dritten negativen Ansteuerpotential (AP3-) auf ein zweites positives Ansteuerpotential (AP2+), eingeschaltet wird, so dass beide schaltbare Leistungshalbleiter (T1, T2, T) eingeschaltet sind,
- daraufhin eine Auswertung (AW) des ersten Diodenstroms (ID1) der ersten Freilaufdiode (D1, D) des ersten schaltbaren Leistungshalbleiters (T1, T) erfolgt, und
- bei Vorliegen einer Stromreduzierung (RE) des ersten Diodenstroms (ID1) zu einem nach dem zweiten Zeitpunkt (t2) folgenden dritten Zeitpunkt (t3) der erste schaltbare Leistungshalbleiter (T1, T) mittels eines an seinem ersten Gate (G1, G) anliegenden zweiten negativen Ansteuerpotentials (AP2-) abgeschaltet wird.

2. Ansteuerverfahren nach Anspruch 1, wobei die Stromreduzierung (RE) des ersten Diodenstroms (ID1) mittels eines ersten Spannungsabfalls (UL1) über einer ersten Induktivität (L1) ermittelt wird, welche ein elektrischer Leiter (4) an einem ersten Emitter (E1, E) des ersten schaltbaren Leistungshalbleiters (T1, T) aufweist.

3. Ansteuerverfahren nach Anspruch 2, wobei der erste Spannungsabfall (UL1) durch eine erste Spannungserfassungsvorrichtung (6) ermittelt wird, welche mittels elektrischer Anschlüsse (7) mit dem ersten Emitter (E1, E) und einem ersten Hilfsemitter (HE1, HE) des ersten schaltbaren Leistungshalbleiters (T1, T) elektrisch verbunden ist.

4. Ansteuerverfahren nach einem der vorhergehenden Ansprüche, wobei das zweite negative Ansteuerpotential (AP2-) an das erste Gate (G1, G) des ersten schaltbaren Leistungshalbleiters (T1, T) zum Abschalten dann angelegt wird, wenn die erste Freilaufdiode (D1, D) des ersten schaltbaren Leistungshalbleiters (T1, T) den ersten Diodenstrom (ID1) führt und der erste Spannungsabfall (UL1) über der ersten Induktivität (L1) ermittelt ist.

5. Ansteuerverfahren nach einem der vorhergehenden Ansprüche, wobei insbesondere das zweite negative Ansteuerpotential (AP2-) zum Abschalten des ersten schaltbaren Leistungshalbleiters (T1, T) über einen ersten niederohmigen Gate-Widerstand (RGN1) als separaten Gate-Widerstand (RGS) einer ersten Treibervorrichtung (5) mittels einer ersten separaten Gate-Ansteuerleitung (14) an das erste Gate (G1, G) des ersten schaltbaren Leistungshalbleiters (T1, T) geführt wird.

6. Ansteuerverfahren nach einem der vorhergehenden Ansprüche, wobei das zweite negative Ansteuerpotential (AP2-) zum dritten Zeitpunkt (t3) an das erste Gate (G1, G) des ersten schaltbaren Leistungshalbleiters (T1, T) zu dessen Abschaltung angelegt wird, bevor der erste Diodenstrom (ID1) zu einem vierten Zeitpunkt (t4) einen Wert Null erreicht oder genau dann, wenn der erste Diodenstrom (ID1) zu einem vierten Zeitpunkt (t4) einen Wert Null erreicht.

7. Ansteuerverfahren nach einem der vorhergehenden Ansprüche, wobei das Ansteuerverfahren lediglich durchgeführt wird, wenn der mittels einer Phasenstromerfassungsvorrichtung (9) ermittelte Phasenstrom (IAC) einer Wechselstromphase (AC) größer ist als ein Stromgrenzwert (GW).

8. Vorrichtung (24)zur Durchführung eines Ansteuerverfahrens nach einem der Ansprüche 1 bis 7, aufweisend
- mindestens zwei Leistungshalbleiterchips (1, 12, 13) in einem Brückenzweig (2) einer Brückenschaltung (3),
- einen ersten schaltbaren Leistungshalbleiter (T1, T) mit einer ersten Freilaufdiode (D1, D) im ersten Leistungshalbleiterchip (1, 12)
- einen zweiten schaltbaren Leistungshalbleiter (T2, T) mit einer zweiten Freilaufdiode (D2, D) im zweiten Leistungshalbleiterchip (1, 12),
- eine erste Treibervorrichtung (5) und eine zweite Treibervorrichtung (8), sowie
- mindestens eine Recheneinheit (10),
wobei
- mittels der ersten Treibervorrichtung (5) bis zu einem ersten Zeitpunkt (t1) an das erste Gate (G1, G) des ersten schaltbaren Leistungshalbleiters (T1, T) ein erstes negatives Ansteuerpotential (AP1-) anlegbar ist und ein erster Diodenstrom (ID1) als Phasenstrom (IAC) durch die erste Freilaufdiode (D1, D) geführt werden kann,
- mittels der ersten Treibervorrichtung (5) zu einem ersten Zeitpunkt (t1) an das erste Gate (G1, G) des ersten schaltbaren Leistungshalbleiters (T1, T) ein positives Ansteuerpotential (AP1+) anlegbar ist und der erste schaltbare Leistungshalbleiter (T1, T) eingeschaltet werden kann,
- mittels der zweiten Treibervorrichtung (8) zu einem zweiten Zeitpunkt (t2) an dem zweiten Gate (G2,G) des zweiten schaltbaren Leistungshalbleiters (T2, T) ein Potentialwechsel von einem dritten negativen Ansteuerpotential (AP3-) auf ein zweites positives Ansteuerpotential (AP2+) durchführbar ist und der zweite schaltbare Leistungshalbleiter (T2, T) eingeschaltet werden kann,
- mittels der mindestens einen Recheneinheit (10) eine Auswertung (AW) des ersten Diodenstroms (ID1) der ersten Freilaufdiode (D1, D) des ersten schaltbaren Leistungshalbleiters (T1, T) durchgeführt werden kann,
**dadurch gekennzeichnet, dass** die erste Treibervorrichtung (5) auf Basis der Auswertung (AW) des ersten Diodenstroms (ID1) bei Vorliegen einer Stromreduzierung (RE) zu einem dritten Zeitpunkt (t3) an das erste Gate (G1, G) des ersten schaltbare Leistungshalbleiters (T1, T) ein zweites negatives Ansteuerpotential (AP2-) anlegbar ist und der erste schaltbare Leistungshalbleiter (T1, T) abgeschaltet werden kann.

9. Vorrichtung (24) nach Anspruch 8, wobei die Vorrichtung (24) einen elektrischen Leiter (4) mit einer ersten Induktivität (L1) an einem ersten Emitter (E1, E) des ersten schaltbaren Leistungshalbleiters (T1, T) aufweist, und die Stromreduzierung (RE) des ersten Diodenstroms (ID1) mittels eines ersten Spannungsabfalls (UL1) über der ersten Induktivität (L1) ermittelbar ist.

10. Vorrichtung (24) nach Anspruch 9, wobei die Vorrichtung (24) eine erste Spannungserfassungsvorrichtung (6) aufweist, mittels der der erste Spannungsabfall (UL1) über der ersten Induktivität (L1) in dem elektrischen Leiter (4) ermittelbar ist, und wobei die erste Spannungserfassungsvorrichtung (6) mittels elektrischer Anschlüsse (7) mit dem ersten Emitter (E1, E) und einem ersten Hilfsemitter (HE1, HE) des ersten schaltbaren Leistungshalbleiters (T1, T) elektrisch verbunden ist.

11. Vorrichtung (24) nach einem der vorhergehenden Ansprüche, wobei die Vorrichtung (24) einen ersten niederohmigen Gate-Widerstand (RGN1) als separaten Gate-Widerstand (RGS) der ersten Treibervorrichtung (5) und eine separate Gate-Ansteuerleitung (14) zwischen dem ersten niederohmigen Gate-Widerstand (RGN1) und dem ersten Gate (G1, G) des ersten schaltbaren Leistungshalbleiters (T1, T) aufweist, über dem insbesondere das zweite negative Ansteuerpotential (AP2-) zum Abschalten des ersten schaltbaren Leistungshalbleiters (T1, T) an das erste Gate (G1, G) des ersten schaltbaren Leistungshalbleiters (T1, T) führbar ist.

12. Vorrichtung (24) nach einem der vorhergehenden Ansprüche, wobei die Vorrichtung (24) eine Phasenstromerfassungsvorrichtung (9) zur Ermittlung eines Phasenstroms (IAC) in einer Wechselstromphase (AC) und ein Mittel (23) zur Festlegung eines Stromgrenzwerts (GW) für einen Vergleich (VG) des Phasenstroms (IAC) mit dem Stromgrenzwert (GW)aufweist.

13. Vorrichtung (24) nach einem der vorhergehenden Ansprüche, wobei die Leistungshalbleiterchips (1, 12, 13) als Reverse Conducting Diode-Controlled Insulated-Gate Bipolare Transistors (RCDC-IGBT) ausgebildet sind.

14. Umrichter (15) mit einer Vorrichtung (24) nach einem der Ansprüche 8 bis 12, aufweisend
- einen Gleichspannungszwischenkreis (18) mit einer ersten Gleichstromphase (DC+) und einer zweiten Gleichstromphase (DC-), und
- ein Wechselstromsystem (17) mit mindesten zwei Wechselstromphasen (AC) zum jeweiligen Führen eines Phasenstroms (IAC), wobei jeweils ein Brückenzweig (2) einer Brückenschaltung (3) mit mindestens zwei Leistungshalbleiterchips (1, 12, 13) mittels eines Gleichstromanschlusses (16) mit der ersten und der zweiten Gleichstromphase (DC+, DC-) des Gleichspannungszwischenkreises (18) und mittels eines Wechselstromanschlusses (19) mit einer der Wechselstromphasen (AC) des Wechselstromsystems (17) verbunden ist.
